# EUROPEAN PATENT SPECIFICATION

(11) **EP 3 975 072 B1**
(45) Date of publication and mention of the grant of the patent: **25.06.2025**
(21) Application number: 20198886.2
(22) Date of filing: 29.09.2020
(51) Int. Cl.: G06N 10/40, G06N 10/20, H10D 48/00, H10D 64/27, B82Y 10/00

(54) **QUBIT PROCESSING**
QUBIT-VERARBEITUNG
TRAITEMENT DE BITS QUANTIQUES

(43) Date of publication of application: 30.03.2022
(73) Proprietor: Hitachi, Ltd., Tokyo (JP)
(72) Inventor: Gonzalez Zalba, Fernando, Cambridge, Cambridgeshire (GB)
(74) Representative: Piotrowicz, Pawel Jan Andrzej

(56) References cited:
- GONZALEZ ZALBA FERNANDO ET AL: "Creating Disruptive Technologies for the Next Generation", OPEN INNOVATION FOR THE GLOBAL VALUE CREATION : RESEARCH AND DEVELOPMENT IN COLLABORATIVE CREATION WITH CUSTOMERS : 2019 VOL.68 NO.4, 1 September 2019 (2019-09-01), XP055787547, Retrieved from the Internet <URL:https://www.hitachi.com/rev/archive/2019/r2019_04/pdf/P138-142_R4c03.pdf> [retrieved on 20210318]
- WEST A ET AL: "Gate-based single-shot readout of spins in silicon", ARXIV.ORG, CORNELL UNIVERSITY LIBRARY, 201 OLIN LIBRARY CORNELL UNIVERSITY ITHACA, NY 14853, 6 September 2018 (2018-09-06), XP081143795, DOI: 10.1038/S41565-019-0400-7
- JONES CODY ET AL: "Logical Qubit in a Linear Array of Semiconductor Quantum Dots", PHYSICAL REVIEW X, vol. 8, no. 2, 1 June 2018 (2018-06-01), XP055787550, Retrieved from the Internet <URL:https://journals.aps.org/prx/pdf/10.1103/PhysRevX.8.021058> [retrieved on 20210319], DOI: 10.1103/PhysRevX.8.021058

## Description

### Field

The present invention relates to qubit processing.

### Background

Quantum computation has recently entered a new era, sometime referred to as the "Noisy Intermediate-Scale Quantum" (NISQ), in which quantum advantage has been demonstrated. This remarkable achievement sets an important milestone in quantum computing research and brings focus towards the ultimate goal of the quantum computing roadmap, namely building a universal quantum machine which has sufficient error-free computing resources to run quantum algorithms with the potential to transform society.

The most promising routes to universal quantum computing require quantum error correction (QEC) to enable accurate computing in spite of the intrinsically noisy nature of the individual quantum bits constituting the machine. The idea is based on distributing the logical information in the form of a logical qubit over a number of physical qubits as long as they satisfy a maximum error rate (about 1%) for the most forgiving method, called "the surface code". The surface code requires qubits to be distributed in a two-dimensional array with controllable nearest-neighbour interactions. The exact physical qubit overhead is still a matter of debate but will likely set a figure on excess of the hundreds considering state-of-the-art qubit fidelities, and so the number of required physical qubits is likely to be at least a million. Scaling becomes an important requirement, regardless of whether the physical host for the qubits are superconducting or semiconductor qubits, ion traps, photonic systems or Majorana particles.

Recent breakthroughs in nanodevice engineering have shown that qubits can now be manufactured in a similar fashion to silicon field-effect transistors (FETs), opening up the opportunity to take advantage of know-how in the CMOS industry to address the challenge of scaling. Reference is made to EP 3 082 073 A1.

From a technological perspective, CMOS-based quantum computing brings two key ingredients that may make the FET the basic building block of a cost-effective large-scale quantum information processing systems, namely a small qubit footprint (as compared to other technologies) and compatibility with the highly-reproducible VLSI rules of the CMOS industry that routinely manufacture billions of quasi-identical transistors in the space the size of a fingertip. Furthermore, given that a quantum computer will likely be a submodule of a larger information processing system (which contains analog and digital classical electronics operating in rapid concert with the quantum processing unit), silicon CMOS offers the possibility to integrate those multiple technologies monolithically for data management and fast information feedback.

The reasons for exploring silicon CMOS as a platform for large-scale quantum computing are not exclusively technical but also because of some remarkable advantages from the physics perspective. In silicon, the qubits are embodied in the spins of charged particles at millikelvin temperatures and finite magnetic fields of which simplest example is the spin ½ of a single charge electrostatically confined in a quantum dot at the interface of a MOS nanodevice (typically metal-SiO₂-Si) or Si/SiGe heterostructure. Recently, large enhancements in spin coherence have been demonstrated by isotopically purification of the silicon matrix (²⁸Si), with intrinsic coherence times exceeding 100 µs, placing spins in silicon as one of the most coherent solid-state systems in nature. In terms of operation, spins are initialized and readout using spin-to-charge conversion techniques and manipulated with electron-spin-resonance or spin-exchange-based methods and now, thanks to the increase in coherence, all these steps have been performed to a sufficiently high level of fidelity to claim that attempting to build a fault-tolerant quantum computer based on silicon technology makes sense.

Despite the promising initial results of this relatively modern approach to quantum computing, many technological challenges lie ahead. Most of the results achieved so far come from devices fabricated in academic cleanrooms with relatively low level of reproducibility and in one- or two-qubit systems at best. Recently, however, a qubit has been fabricated in a 300-mm CMOS platform and reference is made to R. Maurand et al.: "A CMOS silicon spin qubit", Nature Communications, volume 7, article number 13575 (2016).

Gonzalez Zalba Fernando ET AL: "Creating Disruptive Technologies for the Next Generation",Open Innovation for the Global Value Creation : Research and Development in Collaborative Creation with Customers : 2019 Vol.68 No.4, 1 September 2019, teaches using complementary metal-oxide semiconductor technology for implementing a general-purpose quantum processor.

### Summary

According to a first aspect of the present invention there is provided a qubit processing unit.

The qubit processing unit comprises a first module adapted for defining a first linear array of N₁ qubits, comprising a first silicon nanowire extending along a first direction having first and second obtuse or acute edges running along the first direction, wherein the first edge is between a first side face and a top or bottom face of the first silicon nanowire and the second edge is between a second side face and the top or bottom face of the first silicon nanowire, first gate dielectric underlying or overlying the first and second edges of the nanowire, wherein the gate dielectric is disposed on the first and second side faces, and on the top face or under the bottom face, the gate dielectric comprising CMOS-compatible material(s) and a first linear array of split gates spaced along the first semiconductor nanowire along the first direction, each split gate running across the first silicon nanowire in a second, transverse direction, each split gate comprising first and second gates underlying or overlying the first and second edges respectively, the gate dielectric interposed between the split gate and the first semiconductor nanowire and the split gate comprising CMOS-compatible material(s).

The qubit processing unit comprises a second module adapted for defining a second linear array of N₂ qubits, comprising a second silicon nanowire extending along a third direction which is transverse to the first direction and which has third and fourth obtuse or acute edges running along the third direction, wherein the third edge is between a third side face and a top or bottom face of the second semiconductor nanowire and the fourth edge is between a fourth side face and the top or bottom face of the second silicon nanowire, second gate dielectric underlying or overlying the third and fourth edges of the nanowire, wherein the gate dielectric is disposed on the third and fourth side faces, and on the top face or under the bottom face, the gate dielectric comprising CMOS-compatible material and a second linear array of split gates spaced along the second semiconductor nanowire along the second direction, each split gate running across the nanowire in a fourth, transverse direction, each split gate comprising third and fourth gates underlying or overlying the third and fourth edges respectively, the gate dielectric interposed between the split gate and the second semiconductor nanowire and the split gate comprising CMOS-compatible material(s).

The qubit processing unit comprises a junction adapted for controllably coupling respective ends of the first and second modules to allow charge and/or spin to be extracted from the end of one of the first and second modules and to be moved so as to be presented to the end of the other of the first and second modules, the junction comprising a two-dimensional silicon channel and at least three gate stacks disposed on the silicon channel so as to provide a series of nodes in a path between the ends of the first and second modules, each stack comprising a gate and a gate dielectric interposed between the silicon channel and the gate, the gate dielectric comprising a CMOS- compatible material and the gate comprising CMOS-compatible material(s).

The qubit processing unit may comprise a common silicon mesa which provides the first and second silicon nanowires and the two-dimensional silicon channel.

N₁ and N₂ may be equal to 16.

The first and third directions may be perpendicular.

The first and second silicon nanowires may have respective first and second lengths L₁, L₂ which lie in a range between 0.05 µm and 50 µm, optionally between 0.1 µm and 10 µm or between 1 µm and 5 µm.

The junction may comprise five gate stacks disposed on the silicon channel in a cruciform including a central gate stack, first and third gates stacks, wherein the first, central and third gate stacks are arranged in a first line running along the first direction and second and fourth gates stacks, wherein the second, central and fourth gate stacks are arranged in a second line running along the second direction. The first and second lines may run through the centre of the central gate stack, wherein the respective centres of the first and third gates stacks are arranged to lie either side of the first line and wherein the respective centres of the second and fourth gates stacks are arranged to lie either side of the second line.

The junction may comprise an array of a×b gate stacks, where a and b are positive, non-zero integers, a ≥ 3 and b ≥ 3 and optionally where a and b are odd numbers, for example a = b = 3.

According to a second aspect of the present invention there is provided apparatus comprising a n×m array of the qubit processing units of the first aspect, where n ≥ 2 and m ≥ 2, where a junction in a first qubit processing unit is connected to a first module of a second first qubit processing unit and a second module of a third qubit processing unit.

According to a third aspect of the present invention there is provided a system comprising the apparatus of the second aspect and a refrigerator for cooling the apparatus to below 1 K.

According to a fourth aspect of the present invention there is provided a system comprising the apparatus of the second aspect or the system of the third aspect and a control and readout system arranged to control the split gates and gates.

According to a fifth aspect of the present invention there is provided a method of operating the qubit processing unit of the first aspect, the method comprising causing an electron to be transferred from under one of the first and second gates in a proximal end split gate of the first module and to be transferred to a first node in the path, causing the electron to be transferred via a second node in the path to a third node adjacent to one of the first and second gates in a proximal end split gate of the second module, performing a two-qubit quantum gate operation, causing the electron to be transferred via the second node to the first node and causing the electron to be transferred to under-one of the first and second gates in a proximal end split gate of the first module.

The two-qubit quantum gate operation may be a CNOT gate.

The method may further comprise, before causing the electron to be transferred from under one of the first and second gates in the proximal end split gate of the first module, performing a single-qubit gate operation.

The junction may comprise at least an array of a×b gate stacks, where a and b are positive, non-zero integers, a ≥ 3 and b ≥ 3 and optionally where a and b are odd numbers, for example a = b = 3, and the method may comprise causing two electrons to be transferred within the junction concurrently.

### Brief Description of the Drawings

Certain embodiments of the present invention will now be described, by way of example, with reference to the accompanying drawings, in which:
Figure 1 is a plan view of a silicon nanowire, split-gate, field-effect transistor for forming a double-quantum dot for defining a single qubit;
Figure 2 is a cross-section through the transistor shown in Figure 1 along a line A-A';
Figure 3 is a plan view of a silicon nanowire having n multiple split-gates for forming n double-quantum dots for defining n qubits;
Figure 4 is a plan view of a silicon nanowire having n multiple split-gates for forming n double-quantum dots for defining n qubits which serves as a one-dimensional quantum computing block (or "module") which can be assembled into a two-dimensional array;
Figure 5 is a plan view of a first junction used to interconnect one-dimensional quantum computing modules which includes a set of shuttling gates;
Figure 6 is a cross-section through a shuttling gate;
Figure 7 is a magnified plan view of a junction;
Figure 8 is a schematic block diagram of a control system;
Figure 9 is a process flow diagram of a method of controlling a junction to shuttle an electron between an X module and a Y module via the junction;
Figure 10 is a process flow diagram of a method of entangling first and second modules;
Figure 11 schematically illustrates electron shuttling;
Figure 12 is a plan view of a two-dimensional array of quantum computing submodules interconnected by junctions in which in X and Y modules there is nearest neighbour connectivity between qubits and there is sparse X-Y connectivity between qubits at the junction;
Figure 13 is a plan view of a second junction which can be used to interconnect one-dimensional quantum computing modules; and
Figure 14 is a plan view of a third junction which can be used to interconnect one-dimensional quantum computing modules.

### Detailed Description of Certain Embodiments

### Introduction

### Building block

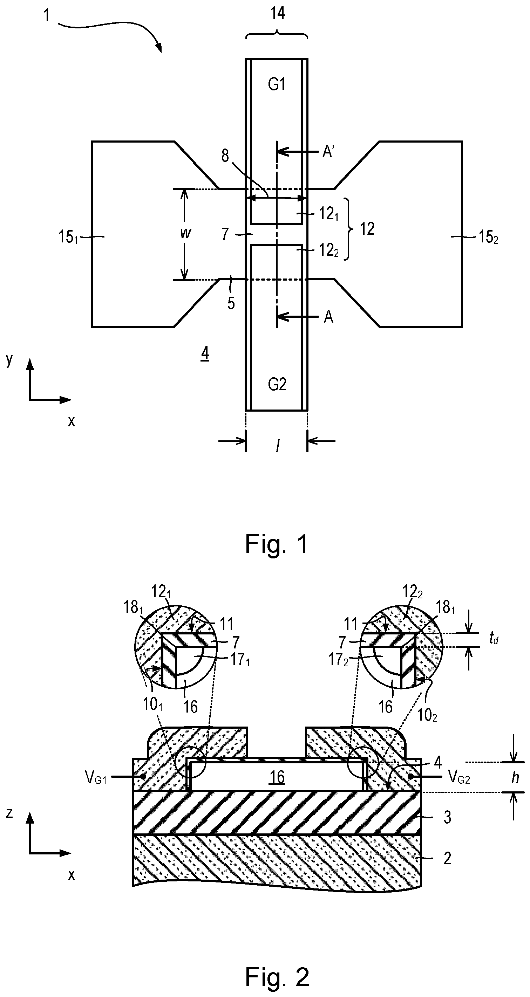

Referring to Figures 1 and 2, a silicon nanowire field-effect transistor device 1 is shown.

The device 1 comprises a silicon substrate 2 and a silicon dioxide layer 3 having an upper surface 4 disposed on the substrate 2. An elongate conductive mesa 5 (or "channel") which is generally rectangular in cross section is disposed on the upper surface 4 of the dielectric layer 3 and runs in a first direction (along the x-axis).

A gate dielectric 7 (best shown in Figure 2) is disposed on a section 8 of the mesa 5. The gate dielectric 7 may be interposed between first and second silicon nitride spacer elements (which may also be referred to simply as "spacers") (not shown). The gate dielectric 7 consists of silicon dioxide (SiO₂) and has a thickness of between 3 and 20 nm, preferably about 5 nm. The gate dielectric 7 may consist of hafnium silicon oxynitride (HfSiON) or another CMOS-compliant high-k dielectric having an equivalent oxide thickness. The gate dielectric 7 is formed on first and second side faces 10₁, 10₂ and a top face 11 of the mesa 5.

A metallic split-gate arrangement 12 runs over the gate dielectric 7 in a second direction (along the y-axis) which is transverse, preferably perpendicular, to the orientation of the mesa 5. The split-gate arrangement 12 comprises first and second gate sections 12₁, 12₂ (hereinafter simply referred to as "top gate electrodes", "gate electrodes" or simply "gates"), each comprising a bi-layer of titanium nitride (TiN) and heavily-doped polycrystalline silicon. Other conductive CMOS-compliant materials, however, can be used.

The part of the device 1 which includes the section 8 of the mesa 5, a corresponding section of the gate dielectric 7 and the split-gate arrangement 12, *i.e*., that excludes the contact regions 15₁, 15₂, can serve as a repeatable unit 14 (herein after referred to as "the split-gate transistor". Thus, the mesa 5 can be lengthen and accommodate two or more units 14.

On either side of the section 8 of the mesa 5 and silicon nitride spacers (if present), the mesa 5 is doped by implantation and annealing to provide contact regions 15₁, 15₂ to an undoped silicon channel 16. The contact regions 15₁, 15₂ can be both be doped n-type or p-type, or be doped differently, *i.e*., one n-type and one p-type, thereby providing contact regions 15₁, 15₂ to an undoped silicon channel 16. Spacer elements (if used) can help provide a steep doping gradient to the channel 16.

The undoped channel 16 has a height, *h*, of between 5 and 20 nm, preferably about 10 nm, and a width, *w*, of about 10 to 100 nm, preferably about 100 nm. The undoped channel 16 may have a length, *l*, of between 20 and 100 nm. The spacers (if used) may each have a length of between 5 and 20 nm, preferably about 11 nm.

The split-gate transistor 14 is used to provide qubits using double quantum dots 17₁, 17₂ formed in corner states (not shown) of the transistor 1. Due to strong electric fields, first and second one-dimensional corner states (not shown) are formed along first and second upper edges 18₁, 18₂ of the mesa 5 between the first side face 10₁ and the top face 11 and between the second side face 10₂ and the top face 11, respectively. The one-dimensional corner states are constricted to zero-dimensional quantum dots 17₁, 17₂. One of the quantum dots 17₁, 17₂ can form a spin qubit or the double quantum dot (not shown) forms charge or singlet-triplet qubit. These are formed without the overhead of gate-crowding found in GaAs and SiGe heterostructures.

Coupling between the quantum dots 17₁, 17₂ can be controlled by a back-gate provided by the handle wafer, *i.e*., the silicon substrate 2. The first and second top gates 12₁, 12₂ provide independent control of electron occupancy in each quantum dot 17₁, 17₂. Further details can be found in EP 3 082 073 A1 *ibid.* which is incorporated herein by reference.

### Single-qubit encoding

A spin-half single electron (or hole) confined to one of the corner dots (not shown) of the pair of corner dots is used as a qubit.

Electron spins in isotopically-purified silicon present long coherence times (T2* > 100 µs) that enable high control fidelity to be achieved via oscillatory magnetic fields that can be applied either locally or globally. Hole-spin qubits present shorter coherence times (T2* > 250 ns). However, because these qubits exhibit larger spin-orbit coupling compared to electron spins, hole-spin qubits can allow all-electrical control at relatively fast rates (~100 MHz) via electrically-driven spin resonance (EDSR).

### Single-spin readout

Single-spin readout can be achieved using gate-based readout charge sensing as described in M. F. Gonzalez-Zalba, S. Barrud, A. J. Ferguson and A. C. Betz: "Probing the limits of gate-based charge sensing", Nature Communications, volume 6, page 6084 (2015) and EP 3 082 073 A1 *ibid..*

One of the split gates 12₁, 12₂ is connected to an electrical resonant circuit (not shown) which is driven at its resonant frequency f₀. The reflected signal is amplified and quadrature demodulated. The magnitude and phase of the reflected signal are functions of the impedance of the double quantum dot.

The readout ancilla spin (right-hand side) is prepared in spin-down configuration. Then a differential positive voltage is applied to the gates the split gates 12₁, 12₂ to move the target spin to the location of the ancilla spin. In the case where the two electron spins are in parallel position, the system is not able to alternate between the (1,1) configuration and the (2,0) configuration and leads to no shift of the magnitude and phase (which is referred to as "spin blockade"). In the case where the target spin is in spin-up configuration, then the system is able to alternate between the (1,1) and the (2,0) configuration leading to a finite quantum capacitance that shift the amplitude and phase response of the resonator. Further details are found under the headings "5 Qubit specific readout" and "6.2 Scalable readout" of EP 3 082 073 A1 *ibid..*

### Single-spin manipulation (single-qubit gates)

Single-qubit rotations are achieved with electron spin resonance techniques involving delivery of oscillatory magnetic (ESR) or electric field (EDSR) pulses. The ESR implementation can be achieved either by providing on-chip microstrips (not shown) - one per row (or column) of the devices at the metal wiring layer (not shown) on top of a CMOS layer - or by placing the chip (on which the transistor is formed) inside a resonant microwave cavity (not shown). For example, to form a microstrip, a patterned metal strip line (not shown), made of, for example Al or Cu, may be formed suitably close to a device row or column, which can generate a magnetic field by driving an electric current through the metal strip line. Excitation is applied globally and the qubits are tuned in and out of resonance making use of the Stark shift using local pulses at the qubit gate. Further details are found under the heading "4.3 Spin Qubit" of EP 3 082 073 A1 *ibid.* Full Bloch sphere qubit control can be achieved by controlling the amplitude and the phase of the oscillatory magnetic field pulses that are delivered to produce the ESR.

### Two-qubit gates

The two-qubit interaction used herein to implement a two-qubit gate is the exchange interaction between two electron spins in separated quantum dots along the same side of the nanowire. For that purpose, two electrons, one in each dot, are loaded and the system starting point is the (1,1) configuration.

The exchange interaction can be switched on and off by means of the gate voltage detuning. At zero detuning (V_{G1}=V_{G2}), electrons are spatially separated and the exchange interaction J→0 and at (V_{G1}>V_{G2}) then J = t, *i.e*., half the tunnel coupling between the two dots of the qubit. The exchange gate rotates the spins with respect to each other producing an accumulated phase between the two spins. For typical values of J=20 µeV, a CZ operation (a quantum operation in which the spin system acquires a π phase) can be achieved in approximately 100 ps. Further details are found under the heading "4.3.2 Two-qubit gate (Exchange Gate +One-qubit gates)" of EP 3 082 073 A1 *ibid.* The CZ gate is not universal. However, a universal quantum gate, cNOT gate, can be synthesised from an appropriate sequence of exchange interactions, in conjunction with particular one qubit gates.

Alternatively, a CNOT gate can be implemented directly by resonant excitation and further details can be found in D. M. Zajac et al.: "Resonantly driven CNOT gate for electron spins", Science, volume 10, page 1126 (2017) which is incorporated herein by reference.

### Scalable qubits

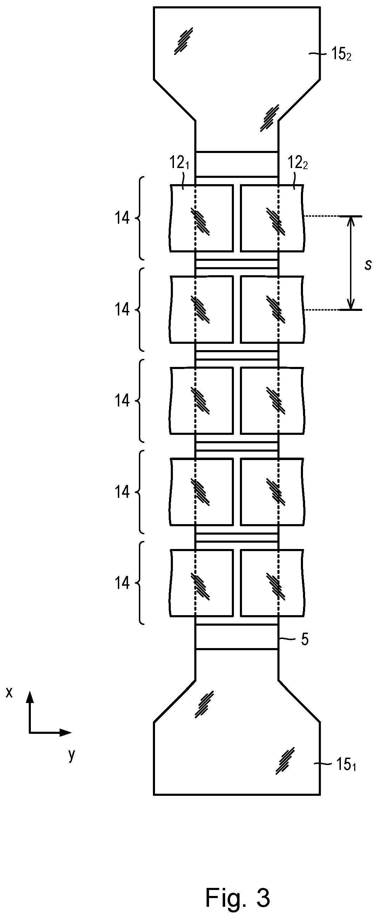

Referring to Figure 3, the architecture can be scaled by fabricating a series of closelyspaced, split-gate transistors 14. The split-gate transistors 14 are placed in series along the length of the same silicon nanowire with source and drain contacts 15, 15₂ at the ends.

Advanced Deep Ultra-Violet (DUV) nanofabrication techniques can be used to obtain a gate pitch, p, which is preferably less than 100 nm so as to enable sizable exchange coupling between spins and more preferably between 40 and 60 nm. The lengths, *l*, of the gates can be between 20 and 100 nm. The architecture consists of a bilinear array of quantum dots, but given that one qubit is encoded in a pair of quantum dots the structure provides an easy way to fabricate long one-dimensional chains of silicon spin qubits. 2×N arrays of quantum dots (where N= number of qubits) can be fabricated using ²⁸Si substrates to form a basic architectural block for the two-dimensional arrays hereinafter described.

This modular approach can enable assembly of two-dimensional networks, as will be explained in more detail hereinafter.

### One-dimensional sub-block (or "module")

The one-dimensional modules hereinbefore described are assembled to form a two-dimensional array with nearest neighbour connectivity in the X and Y direction and sparse connectivity in the XY cross dimension.

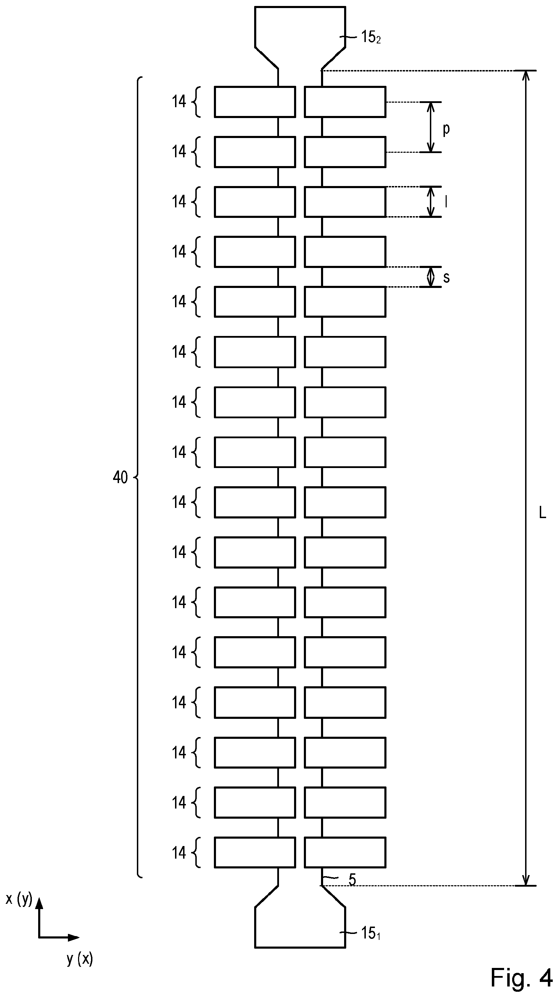

Referring to Figure 4, a one-dimensional submodule 40 is shown.

The number of qubits, N, can lie in a range between 4 and 256 or more (preferably N is a positive, even number), although a value of N = 16 can have benefits.

N=16 allows implementing an error-corrected logical qubit in each module 40. A logical qubit can preserve its quantum state indefinitely by distributing its information over a number of physical qubits. The additional qubits enable readout out of local properties of the logical qubit that do not destroy the global quantum state. By doing so it is possible to detect quantum errors and then by performing operations on the physical qubits the errors can be corrected. Reference is made to C. Jones et al.: "Logical Qubit in a Linear Array of Semiconductor Quantum Dots", Physical Review X, volume 8, page 021058 (2018).

Using N=16 can provide sufficient space between modules 40 to route the lines (not shown) that connect to the metallic gates. Furthermore, it can provide space for cryogenic classical electronics (if used) for fast data processing of binary outputs of the quantum processor. Generally, information exchange tends to be more efficient if the spacing between two qubits is less than around 100 nm.

Fabricating qubits and the classical control layer using the same technology (*i.e*., CMOS) can facilitate integration process, improving feedback speeds in errorcorrection protocols and making wiring and layout easier. Expressed differently, integrating classical and quantum devices monolithically, using CMOS processes, can enable a quantum processor to benefit from mature chip-fabrication technologies used for fabricating of large-scale circuits.

### Junction

### Design

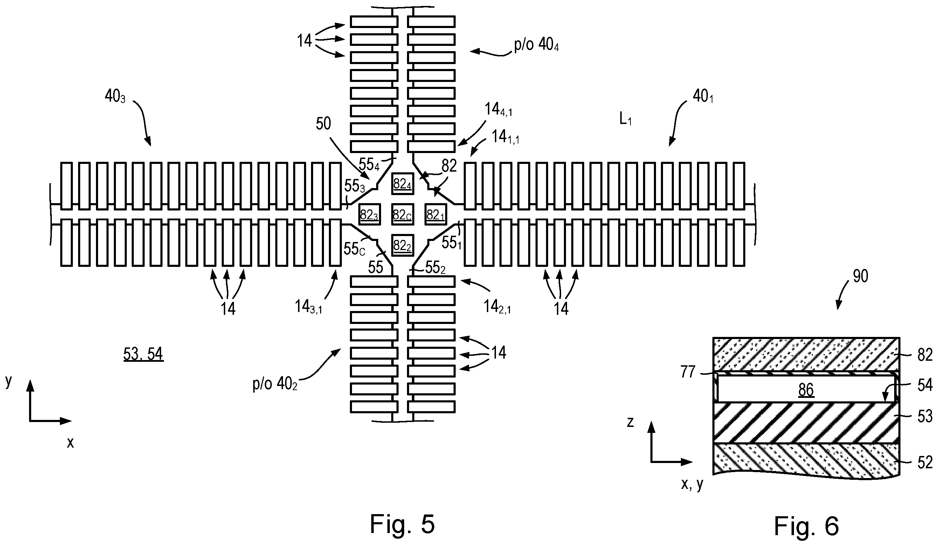

Referring to Figure 5, a set of one-dimensional modules 40₁, 40₂, 40₃, 40₄ and a first type of junction 50 which couples the one-dimensional modules 40₁, 40₂, 40₃, 40₄ are shown.

The modules 40₁, 40₂, 40₃, 40₄ and the junction 50 are formed on a silicon substrate 52 (Figure 6) formed on a silicon dioxide layer 53 having an upper surface 54 disposed on the substrate 52 (Figure 6). The modules 40₁, 40₂, 40₃, 40₄ and the junction 50 share a conductive mesa 55.

The conductive mesa 55 is disposed on the upper surface 54 of the dielectric layer 53, and includes a generally-square central portion 55_{C} (which is rotated by 45° around the z-axis with respect to the x axis) and elongate portions 55₁, 55₂, 55₃, 55₄ extending away from the central potion 55_{C} from its vertices, angularly-spaced by 90°, forming a cruciform shape. As will be explained in more detail later, each elongate portion 55₁, 55₂, 55₃, 55₄ can be connect to another central portion 55_{C} at its other end.

The modules 40₁, 40₂, 40₃, 40₄ are configured as hereinbefore described. Each module 40₁, 40₂, 40₃, 40₄ includes a series of N split-gate transistor 1 arranged along the elongate portions 55₁, 55₂, 55₃, 55₄ of the mesa and include a split-gate isolated from the mesa by a gate dielectric. Preferably, N = 16.

The modules 40₁, 40₂, 40₃, 40₄ and the junction 50 are co-planar and arranged, in this example, in a cruciform shape (in plan view). The junction 50 is arranged to connect two modules 40₁, 40₃ running along a first direction (herein referred to as "X modules") and two submodules 40₂, 40₄ running along a second, transverse (preferably perpendicular) direction (herein referred to as "Y modules").

The junction 50 includes a set of gates 82 (collectively referred to as "shuttling gates") including a central shuttling gate 82_{C}, disposed in the centre of the junction 50, flanked by, in this example, four intermediate shuttling gates 82₁, 82₂, 82₃, 82₄ arranged in cross geometry. Each intermediate gate 82₁, 82₂, 82₃, 82₄ interposed between the central gate 82_{C} and a respective proximal split-gate transistor 14_{1,1}, 14_{2,1}, 14_{3,1}, 14_{4,1}. The gates are generally rectangular (e.g., square) in plan view.

Referring also to Figure 6, gate dielectric 77 is interposed between the metallic gate 82 and underlying silicon region 86 so as to provide gate isolation and form a gate stack 90.

The gate stack 90 can be the same as the gate stack used for the split-gate transistors 1 for ease of fabrication, but different gate stack arrangements can be used. For example, a polysilicon-SiO₂ gate stack with a SiO₂ thicknesses of between 3-20 nm can be used. Alternatively, aluminium-SiO₂ gate stacks can be used. More complex high-k dielectric gate stacks can be used, for example containing high-k dielectric (HfO, HfSiON) and heterometalic structures (TiN and poly-silicon).

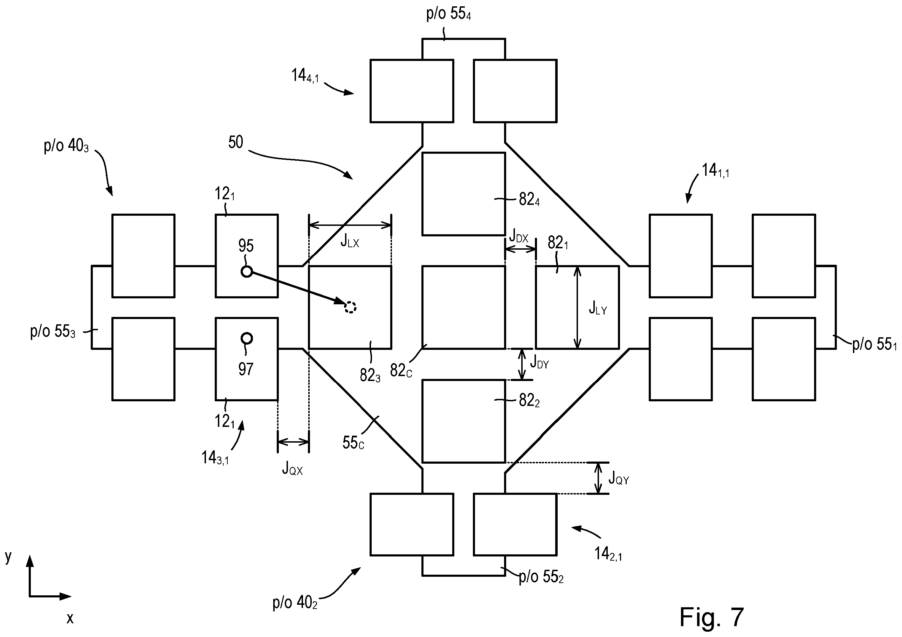

Referring also to Figure 7, the junction 50 is shown in more detail.

The shuttling gates 82_{C}, 82₁, 82₂, 82₃, 82₄ have first and second lateral dimensions ("side lengths") J_{LX}, J_{LY} along the first and second directions (in this case x- and y-directions) respectively. The shuttling gates are laterally separated by first and second separations J_{DX}, J_{DY} along the first and second directions, respectively. The shuttling gates and the proximal split gate are laterally separated by third and fourth separations J_{QX}, J_{QY} along the first and second directions respectively. In this configuration, the gates are distributed in a cross geometry, J_{LX} = J_{LY} = 40 - 80 nm, J_{DX} = J_{DY} = 20 - 60 nm and J_{QX} = J_{QY} = 20 - 60 nm.

### Control and readout system

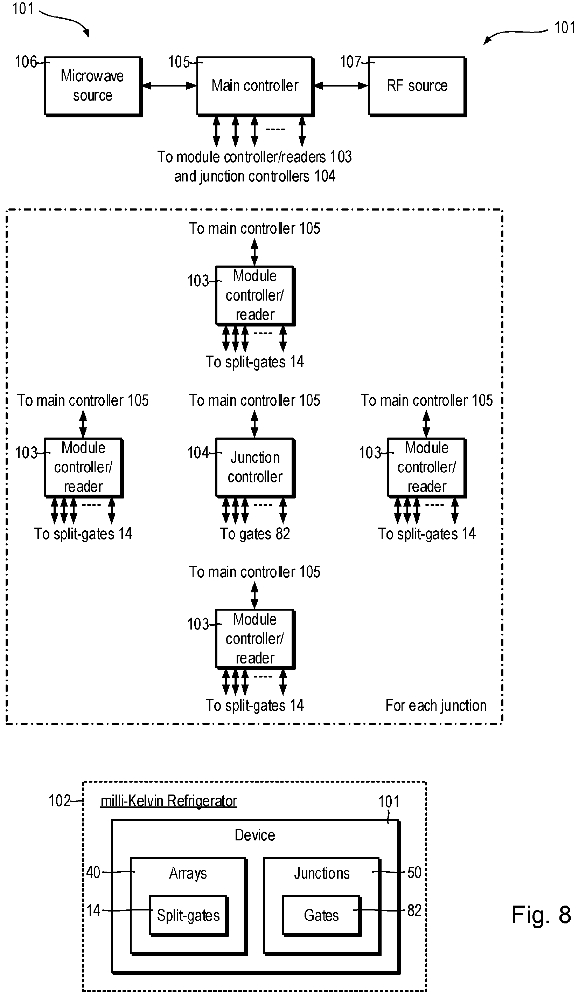

Referring to Figure 8, a control and readout system 100 is shown.

A device 101 comprising an array of modules 40 and junctions 50 can be cooled using a suitable milli-Kelvin refrigerator 102.

The control and readout system 100 can include a module controller 103 (which can also serve as a reader) for each respective module 40 and a junction controller 104 for each respective junction 50.

A module controller 103 can be used to apply suitable time-varying bias voltages to the split gates 14 so as to control qubits and to perform readout of qubits, for example, as described in EP 3 082 073 A1 *ibid.* using reflectometry circuits (not shown) or another, different suitable approach. Each module controller 103 may include one reflectometry circuit (not shown) per split gate 14a and, thus, per qubit.

A junction controller 104 can be used to apply suitable time-varying bias voltages to the junction gates 82. The junction controller 104 can also be used to perform readout.

The module and junction controllers 103, 104 may be controlled by a main controller 105 for co-ordinating operation. The main controller 105 may take the form of a computer system. The main controller 105 may also control microwave source(s) 106 and rf signal source(s) 107. A source 106, 107 can be used to apply a signal (e.g., microwave signal) globally to the whole device 101.

### Operation

Referring again to Figure 5, the junction 50 serves as a shuttling path for electrons at the edges of the one-dimensional modules 40₁, 40₂, 40₃, 40₄. Electrons can be moved, on demand, around the junction 50 in x- and y-directions using appropriate gate voltages. Manipulated electrons can be moved so as to be in sufficiently close proximity with electrons at the edge of another one-dimensional, and a two-qubit gate can then be performed. A two-qubit gate, such as the CNOT, can generate and entangled states between modules 40₁, 40₂, 40₃, 40₄ resulting in an extended entanglement across modules 40₁, 40₂, 40₃, 40₄.

A two-bit gate can be implemented using a CZ gate and a CNOT gate, for example, as described in M. Veldhorst et al.: "A two-qubit logic gate in silicon", Nature, volume 526, page 410 (2015) and T. F. Watson et al.: "A programmable two-qubit quantum processor in silicon", Nature volume 555, page 633 (2018), and in D. M. Zajac et al.: "Resonantly driven CNOT gate for electron spins" *ibid.,* respectively

Herein, operation of the junction 50 is described using the resonant CNOT gate. The CNOT gate combined with single qubit gates provides a complete set of quantum gates, i.e., enabling universal quantum computing. The CZ gate, however, can be combined with single qubit gates to perform a CNOT gate.

### Entangling X and Y modules via CNOT gate

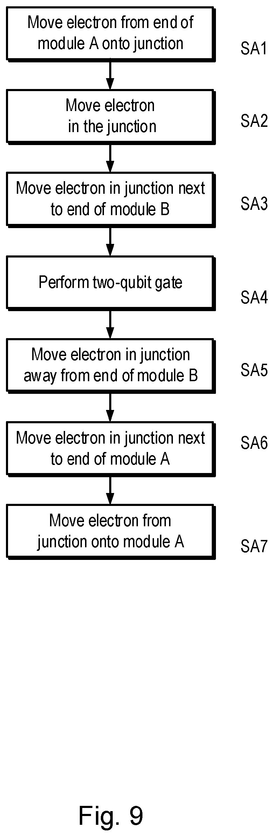

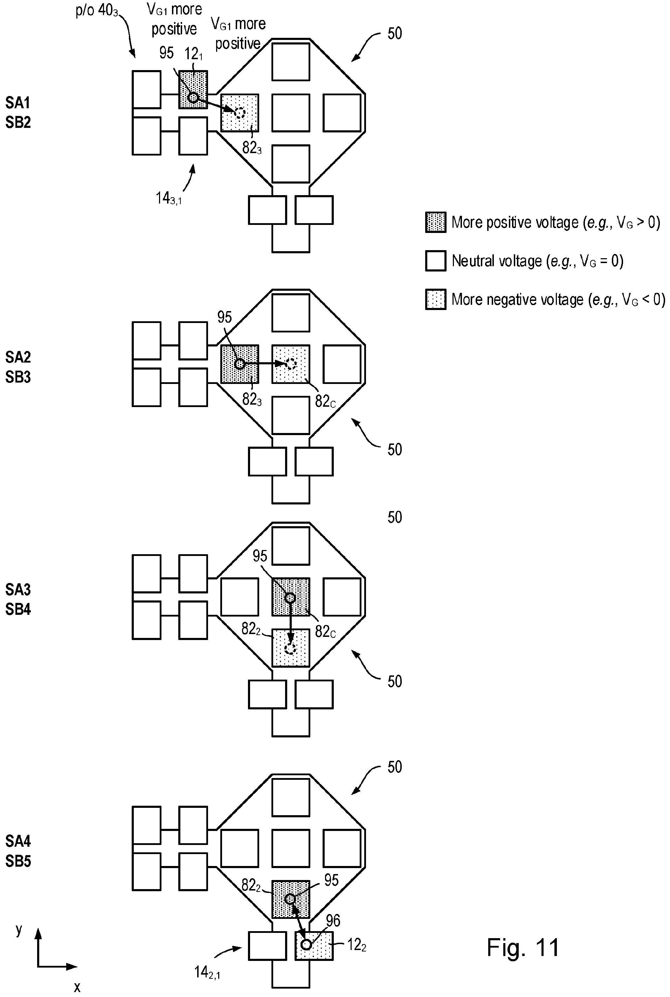

Referring to Figures 9 and 11, a method of entangling X and Y modules entangled via a resonant CNOT gate will now be described.

The control system 100 applies a negative differential voltage to move an electron 95 from a module 40 ("module A") onto to the junction 50 (step SA1). In this example, the control system 100 applies negative differential voltage between a first gate 12₁ in the proximal split-gate 14_{3,1} ("the top-left gate") in the third (X) module 40₃ and the corresponding intermediate gate 82₃ ("the left gate") in the junction 50. This moves an electron 95 from under the top left gate 12₁ to under the left gate 82₃ in the junction 50.

The control system 100 applies a negative differential voltage to move the electron 95 in the junction 50 (step SA2). The control system 100 applies a negative differential voltage between the left gate 82₃ and the central gate 82_{C} in the junction 50. This moves the electron 95 from under the left gate 83_{C} to under the central gate 82_{C}.

The control system 100 applies a negative differential voltage to move the electron 95 again in the junction 50 towards the end of another module 40 ("module B") (step SA3). The control system 100 applies a negative differential voltage between the central gate 82_{C} in the junction 50 and the corresponding intermediate gate 82₂ ("the bottom gate") in the junction 50 the central gate 82C and the proximal split-gate 14_{2,1} in the second (Y) module 40₂. This moves the electron 95 from under the central gate 83_{C} to under the bottom gate 82₂.

A two-qubit gate is performed, for example, as described in D. M. Zajac et al.: "Resonantly driven CNOT gate for electron spins" *ibid*., between the electron 95 and another electron 96 in other module 40 (step SA4). The control system 100 applies a positive differential voltage between the electron 95 under the bottom gate 82₂ and a second gate 12₂ ("the right gate") in the proximal split-gate 14_{2,1} in the second (Y) module 40₂. This increases the exchange coupling between the two spins. Under this condition, the control system 100 causes application of microwave pulses, *e.g*., by the microwave source 37 (Figure 8), to rotate one spin of the pair of electrons 95, 96, conditional on the state of the other spin. Thus, the CNOT gate is directly performed.

The control system 100 then moves the electron 95 back to the original module 40, in this case to back to under the top-left gate 12₁, by performing steps SA1, SA2 and SA3 in reverse order (i.e., step SA3, then step SA2 and then step SA1) using inverted, *i.e*., positive, differential voltages (steps SA5 to SA7).

### Entangling X and Y modules via CZ gate

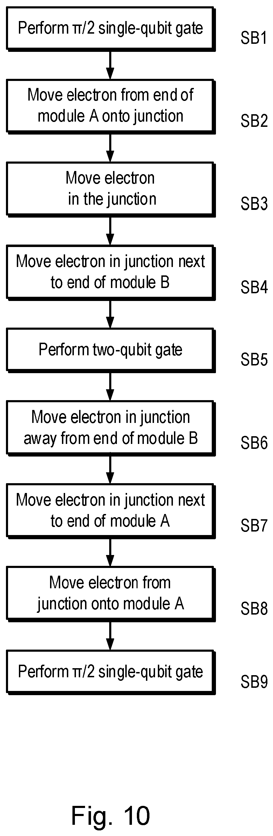

Referring to Figures 10 and 11, a method of entangling X and Y modules entangled via a resonant CZ gate will now be described.

The control system 100 performs a π/2 single-qubit gate of an electron 95 under one of the gates of a proximal split-gate in a module 40 ("module A") (step SB1). In particular, the control system 100 performs a π/2 single-qubit gate of the electron 95 under the first gate 12₁ in the proximal split-gate 14_{3,1} ("the top-left gate") in the third (X) module 40 using timed microwave magnetic field pulses. Further details are found under the heading "4.2.1 Single Qubit Control" of EP 3 082 073 A1 *ibid.*

The control system 100 applies a negative differential voltage to move the electron 95 from module A onto to the junction 50 (step SB2). The control system 100 applies negative differential voltage between the top-left gate 12₁ and the corresponding intermediate gate 82₃ ("the left gate") in the junction 50. This moves the electron 95 from under the top-left gate 12₁ to under the left gate 82₃ in the junction 50.

The control system 100 applies a negative differential voltage to move the electron 95 in the junction 50 (step SB3). The control system 100 applies a negative differential voltage between the left gate 82₃ and the central gate 82_{C} in the junction 50. This moves the electron 95 from under the left gate 83_{C} to under the central gate 82_{C}.

The control system 100 applies a negative differential voltage to move the electron 95 again in the junction 50 towards the end of another module 40 ("module B") (step SB4). The control system 100 applies a negative differential voltage between the central gate 82_{C} in the junction 50 and the corresponding intermediate gate 82₂ ("the bottom gate") in the junction 50 the central gate 82_{C} and the proximal split-gate 14_{2,1} in the second (Y) module 40₂. This moves the electron 95 from under the central gate 83_{C} to under the bottom gate 82₂.

A two-qubit gate is performed between the electron 95 and another electron 96 in other module 40 (step SB5). The control system 100 applies a positive differential voltage between the electron 95 under the bottom gate 82₂ and a second gate 12₂ ("the right gate") in the proximal split-gate 14_{2,1} in the second (Y) module 40₂. This increases the exchange coupling between the two spins. Under this condition, the control system 100 applies a detuning voltage for the appropriate period of time to perform a π-rotation of the one spin in the reference frame of the other spin. Further details are found under the heading "4.3.2 Two-qubit gate (Exchange Gate+One-qubit gates)" of EP 3 082 073 A1 *ibid*., M. Veldhorst et al.: "A two-qubit logic gate in silicon" *ibid.* and T. F. Watson et al.: "A programmable two-qubit quantum processor in silicon" *ibid.*

The control system 100 then moves the electron 95 back to the original module 40, in this case, the top-left gate 12₁, by performing steps SB2, SB3 and SB4 in reverse using inverted, i.e., positive, differential voltages (steps SB6 to SB8).

The control system 100 performs a π/2 single-qubit gate of the electron 95, i.e., the electron under the top-left gate 12₁ (step SB9) using timed microwave magnetic field pulses. Further details are found under the heading "4.2.1 Single Qubit Control" of EP 3 082 073 A1 *ibid.*

### Scaling to large 2D arrays with sparse X-Y connectivity

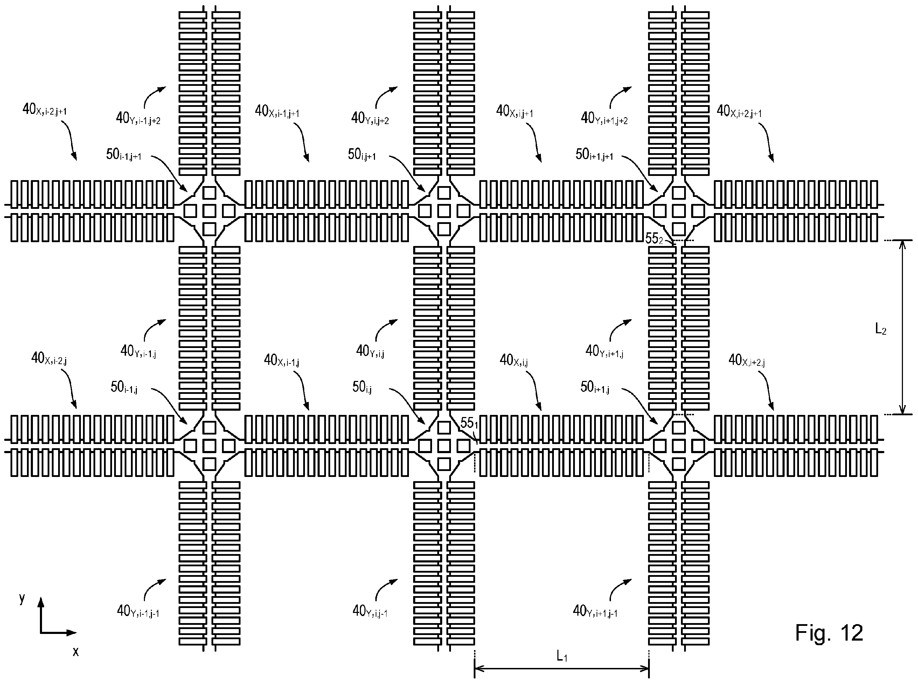

Referring to Figure 12, an array of one-dimensional modules 40_{X,i,j}, 40_{Y,i,j} and junctions 50_{i,j} which couples the one-dimensional modules 40_{X,i,j}, 40_{Y,i}, are shown.

The X modules 40_{X,i,j} and Y modules 40_{Y,i,j} are formed using nanowires 55₁, 55₂ having respective lengths L₁, L₂ of about 1.5 µm. The nanowires can be shorter, for example, as short as 0.5 µm or longer, for example, 50 µm or more.

In this case, each junction 50_{i,j} connects two X modules 40_{X,i,j} and two Y modules 40_{Y,i,j}, and the end of each of those modules 40_{X,i,j}, 40_{Y,i,j} can be connected to a new junction 50_{i,j}. The modular approach enables extending the architecture as required. The approach can provide a large number (>10,000) of junctions. For example, if a junction building block (or "junction unit") occupies 2 × 2 µm², then a junction unit density of about 2.5 × 10⁵ mm⁻² can be achieved. Therefore, a single chip may be able to support an array having a large number of junctions.

Within X modules 40_{X,i,j}, the target spins have nearest neighbour interactions with their X adjacent spins. The target spins at the edge of the junction have nearest neighbour interaction to X as well. Conversely, within Y modules 40_{Y,i,j}, the target spins have nearest neighbour interactions with their Y adjacent spins. The target spins at the edge of the junction have nearest neighbour interaction to Y as well.

### Variations of the junction design

The first type of junction 50 (Figure 7) hereinbefore described is a relatively simple configuration. The junction 50, however, can be configured in other, different ways, which can enhance its functionality and/or provide additional functionalities.

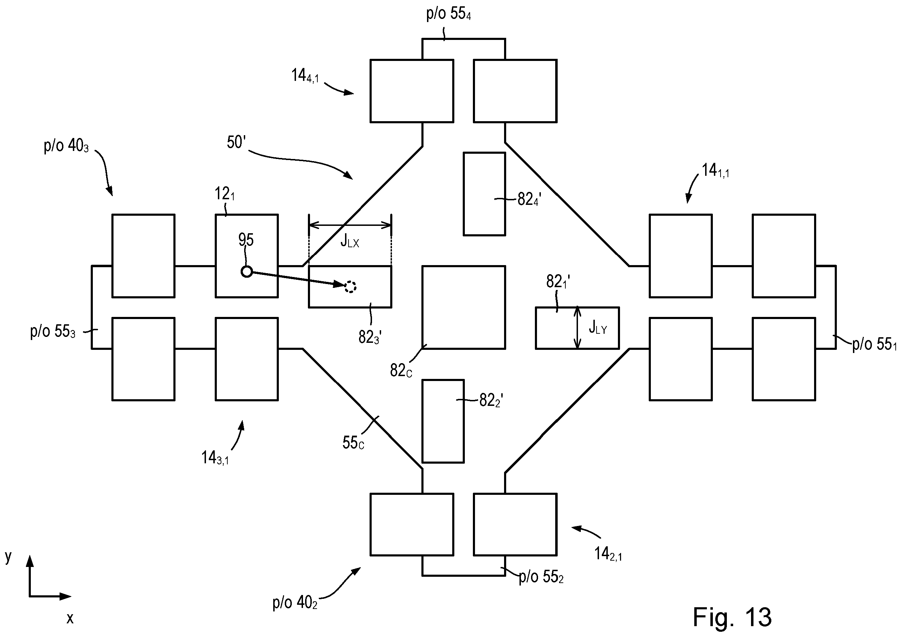

Referring to Figure 13, a second type of junction 50' is shown in which the flanking gates 82₁', 82₂', 82₃', 82₄' on the junction 50' are rectangular in plan view. In particular, J_{LX} > J_{LY}. This arrangement can provide more selective movement of electrons at the edges of the one-dimensional modules 40.

Referring to Figure 7, in the first type of junction 50, when shuttling a target electron 95 from the top-right gate 12₁ of the X module 40₃ to the left gate 82₃' in the junction 50', a compensating signal in the bottom-right gate 12₂ of the X module 40₃ should be applied in order to shuttle the target spin 95 but not the ancilla spin 97. The second junction 50', the gates 82₁', 82₂', 82₃', 82₄' enable shuttling without the need for the additional compensating pulse.

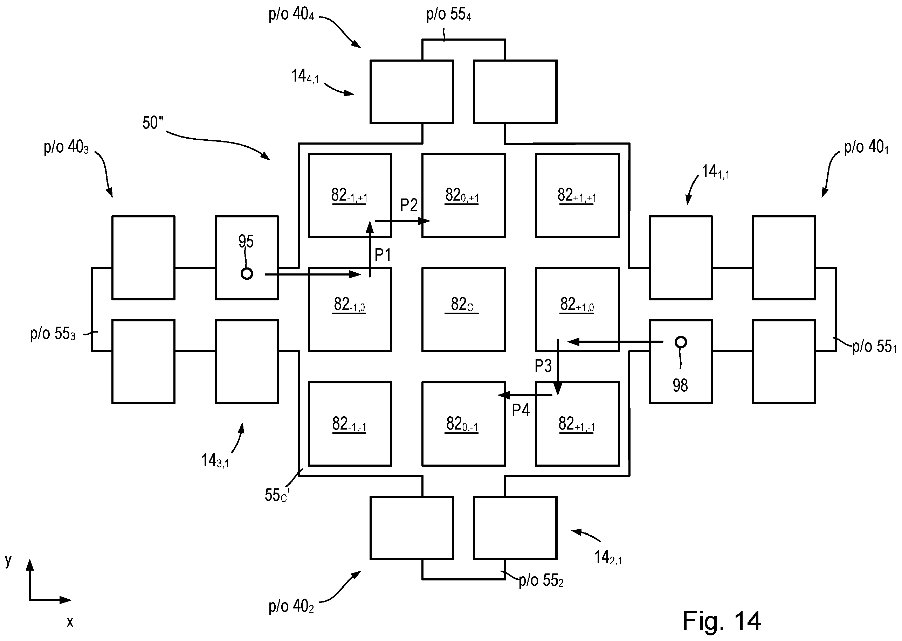

Referring to Figure 14, a third type of junction 50‴ is shown.

In this junction 50‴, the central mesa 55C' is not rotated by 45° around the z-axis with respect to the x-axis and the elongate mesas 55₁, 55₂, 55₃, 55₄ extend outwardly from the middle of the sides off the central mesa 55C' (and not the vertices).

Furthermore, the junction 50‴ has an array of 3×3 gates 82_{-1,-1}, 82_{0,-1}, ...82C ... 82_{0,+1}, 82_{+1,+1} are disposed on top of the junction 50". This arrangement enables simultaneous entanglement to be performed between two different X-Y submodule combinations or between X-X and Y-Y combination. More particularly, this configuration enables shuttling of two different electrons simultaneously and independently in the junction 50‴.

In the case of a simultaneous X-Y entangling operation, an electron 95 from the third ("left X") module 40₃ can be rotated clockwise (along path P1 & P2) until it meets the fourth ("top Y") module 40₄ and an electron 98 from the first ("right X") module 40₁ can be rotated clockwise (along path P3 & P4) until it meets the second ("bottom Y") module 40₂.

In the case of X-X and Y-Y simultaneous entanglement, an electron from the X and Y modules 40₃, 40₂ can be shuttled under the gates in the junction closest to them, then shuttled clockwise until they meet an X or Y submodule respectively and then shuttled back anticlockwise.

### Uses

In accordance with the present invention, quantum computing devices can be readily manufactured using current silicon fabrication facilities.

In a scaled-up device, an exponentially large superposition of entangled qubits can be provided using a linear amount of resources. It can, therefore, be used to implement quantum computation algorithms such as, for example fast database searches using Grover's algorithm or efficient factorisation of large numbers using Shor's algorithm. The latter is of particular utility in digital cryptography.

Furthermore, quantum computing devices can be used to model complex systems. Again, due to the only linear increase in computation time with respect to the complexity of the problem, more advanced systems can be modelled. Particular examples include the folding of proteins, optimisation of networks and the simulations of complex quantum many-body systems.

Due to the need of operating quantum computers at low temperatures, embodiments could be used in a server or cloud like operation mode, where the tasks are sent to the centralised quantum computer, fulfilled and returned to the user online.

### Modifications

It will be appreciated that various modifications may be made.

The junction may couple fewer than four one-dimensional modules (for example, three) or more than four one-dimensional modules, for example, six one-dimensional modules. For example, the modules may be arranged in a hexagonal pattern.

In a junction, the gate stacks need not be rectangular or square in plan view. For example, a gate stack can be regular polygonal (for example, hexagonal or octagonal) or circular.

Other materials, particularly CMOS process compatible materials, can be used to fabricate the modules and junctions herein described. For example, a nanowire need not be formed from silicon, but can be formed from silicon-germanium (SiGe) or, in some cases, a III-V alloy, such as gallium arsenide (GaAs). A gate dielectric need not be formed from silicon dioxide (SiO₂), but can be formed from silicon nitride (SiₓN_{y}), silicon oxynitride (SiON), a high-k dielectric, such as hafnium dioxide (HfO₂), hafnium silicate (HfSiO₄), zirconium oxide (ZrO₂) or zirconium silicate (ZrSiO₄), and the like. A gate metallization need not be formed from poly-silicon, but can be formed from aluminium (Al), copper (Cu), titanium/titanium nitride (Ti/TiN) or tantalum-tantalum nitride (Ta/TaN) , and the like.

## Claims

1. A qubit processing unit comprising:
· a first module (40₃) adapted for defining a first linear array of N₁ qubits, comprising:
- a first silicon nanowire (55₃) extending along a first direction having first and second obtuse or acute edges running along the first direction, wherein the first edge is between a first side face and a top or bottom face of the first silicon nanowire and the second edge is between a second side face and the top or bottom face of the first silicon nanowire;
- first gate dielectric (7) underlying or overlying the first and second edges of the nanowire, wherein the gate dielectric is disposed on the first and second side faces, and on the top face or under the bottom face, the gate dielectric comprising CMOS-compatible material(s); and
- a first linear array of split gates (14) spaced along the first semiconductor nanowire along the first direction, each split gate running across the first silicon nanowire in a second, transverse direction, each split gate comprising first and second gates (12₁, 12₂) underlying or overlying the first and second edges respectively, the gate dielectric interposed between the split gate and the first semiconductor nanowire and the split gate comprising CMOS-compatible material(s);
· a second module (40₂) adapted for defining a second linear array of N₂ qubits, comprising:
- a second silicon nanowire (552) extending along a third direction which is transverse to the first direction and which has third and fourth obtuse or acute edges running along the third direction, wherein the third edge is between a third side face and a top or bottom face of the second semiconductor nanowire and the fourth edge is between a fourth side face and the top or bottom face of the second silicon nanowire;
- second gate dielectric (7) underlying or overlying the third and fourth edges of the nanowire, wherein the gate dielectric is disposed on the third and fourth side faces, and on the top face or under the bottom face, the gate dielectric comprising CMOS-compatible material; and
- a second linear array of split gates (14) spaced along the second semiconductor nanowire along the second direction, each split gate running across the nanowire in a fourth, transverse direction, each split gate comprising third and fourth gates (12₁, 12₂) underlying or overlying the third and fourth edges respectively, the gate dielectric interposed between the split gate and the second semiconductor nanowire and the split gate comprising CMOS-compatible material(s);
· a junction (50) adapted for controllably coupling respective ends of the first and second modules to allow charge and/or spin to be extracted from the end of one of the first and second modules and to be moved so as to be presented to the end of the other of the first and second modules, the junction comprising:
- a two-dimensional silicon channel (86); and
- at least three gate stacks (82₃, 82_{C}, 82₂) disposed on the silicon channel so as to provide a series of nodes in a path between the ends of the first and second modules, each stack comprising a gate (82; Fig. 6) and a gate dielectric (77; Fig. 6) interposed between the silicon channel and the gate, the gate dielectric comprising a CMOS-compatible material and the gate comprising CMOS-compatible material(s).

2. The qubit processing unit of claim 1, comprising:
a common silicon mesa (55) which provides the first and second silicon nanowires (55₃, 55₂) and the two-dimensional silicon channel (86).

3. The qubit processing unit of claim 1 or 2, wherein N₁ = N₂ = 16.

4. The qubit processing unit of any one of claims 1 to 3, wherein the first and third directions are perpendicular.

5. The qubit processing unit of any one of claims 1 to 4, wherein the first and second silicon nanowires (55₃, 55₂) have first and second lengths L₁, L₂ which lie in a range between 0.5 µm and 50 µm, optionally between 1 µm and 5 µm.

6. The qubit processing unit of any one of claims 1 to 5, wherein the junction (50) comprises:
five gate stacks disposed on the silicon channel (86) in a cruciform including:
a central gate stack (82_{C});
first and third gates stacks (82₁, 82₃), wherein the first, central and third gate stacks are arranged in a first line running along the first direction; and
second and fourth gates stacks (82₂, 82₄), wherein the second, central and fourth gate stacks are arranged in a second line running along the second direction.

7. The qubit processing unit of claim 6, wherein the first and second lines run through the centre of the central gate stack (82_{C}), wherein the respective centres of the first and third gates stacks (82₁, 82₃) are arranged to lie either side of the first line and wherein the respective centres of the second and fourth gates stacks (82₂, 82₄) are arranged to lie either side of the second line.

8. The qubit processing unit of any one of claims 1 to 7, wherein the junction (50) comprises:
an array of a×b gate stacks (82₋₁₋₁, 82_{0,-1}, ...82_{C} ... 82_{0,+1}, 82₊₁₊₁), where a and b are positive, non-zero integers, a ≥ 3 and b ≥ 3 and, optionally, where a and b are odd numbers, for example a = b = 3.

9. Apparatus, comprising:
an n×m array of the qubit processing units of any one of claims 1 to 8, where n ≥ 2 and m ≥ 2, where a junction (50_{i,j}) in a first qubit processing unit is connected to a first module (40_{X,i,j}) of a second first qubit processing unit and a second module (40_{Y,i,j}) of a third qubit processing unit.

10. A system comprising:
the apparatus of claim 9; and
a refrigerator (102) for cooling the apparatus to below 1 K.

11. A system, comprising:
the apparatus of claim 9 or the system of claim 10; and
a control and readout system (100) arranged to control the split gates (14) and gates (82).

12. A method of operating the qubit processing unit of any one of claims 1 to 8, the method comprising:
causing an electron (95) to be transferred from under one of the first and second gates (12₁) in a proximal end split gate (14_{3,1}) of the first module (40₃) and to be transferred to a first node (82₃) in the path;
causing the electron to be transferred via a second node (82_{C}) in the path to a third node (82₂) adjacent to a one of the first and second gates (12₂) in a proximal end split gate (14_{2,1}) of the second module (40₂);
performing a two-qubit quantum gate operation;
causing the electron to be transferred via the second node to the first node; and
causing the electron to be transferred to under one of the first and second gates in a proximal end split gate of the first module.

13. The method of claim 12, wherein the two-qubit quantum gate operation is a CNOT gate (SB₁).

14. The method of claim 12 or 13, further comprising:
before causing the electron (95) to be transferred from under one of the first and second gates (12₁) in the proximal end split gate (14_{3,1}) of the first module (40₃), performing a single-qubit gate operation.

15. The method of any one of claims 12 to 14, wherein the junction (50") comprises at least an array of a×b gate stacks (82₋₁₋₁, 82_{0,-1}, ...82_{C} ... 82_{0,+1}, 82₊₁₊₁), where a and b are positive, non-zero integers, a ≥ 3 and b ≥ 3 and, optionally, where a and b are odd numbers, for example a = b= 3, the method comprising:
causing two electrons (95, 98) to be transferred within the junction concurrently.

## Patentansprüche

1. Qubit-Verarbeitungseinheit, umfassend:
• ein erstes Modul (40₃), das zum Definieren eines ersten linearen Arrays von N₁ Qubits ausgelegt ist, umfassend:
- einen ersten Silicium-Nanodraht (55₃), der sich entlang einer ersten Richtung erstreckt und eine erste und eine zweite stumpfe oder spitze Kante aufweist, die entlang der ersten Richtung verlaufen, wobei die erste Kante zwischen einer ersten Seitenfläche und einer oberen oder unteren Fläche des ersten Silicium-Nanodrahts liegt und die zweite Kante zwischen einer zweiten Seitenfläche und der oberen oder unteren Fläche des ersten Silicium-Nanodrahts liegt;
- ein erstes Gatter-Dielektrikum (7), das unter oder über der ersten und der zweiten Kante des Nanodrahts liegt, wobei das Gatter-Dielektrikum auf der ersten und der zweiten Seitenfläche und auf der oberen Fläche oder unter der unteren Fläche vorgesehen ist, wobei das Gatter-Dielektrikum CMOS-kompatible(s) Material(ien) umfasst; und
- ein erstes lineares Array von geteilten Gattern (14), die entlang des ersten Halbleiter-Nanodrahts entlang der ersten Richtung beabstandet sind, wobei jedes geteilte Gatter über den ersten Silicium-Nanodraht in einer zweiten, quer verlaufenden Richtung verläuft, wobei jedes geteilte Gatter ein erstes und ein zweites Gatter (12₁, 12₂) umfasst, die unter oder über der ersten bzw. der zweiten Kante liegen, wobei das Gatter-Dielektrikum zwischen dem geteilten Gatter und dem ersten Halbleiter-Nanodraht zwischengeschaltet ist und das geteilte Gatter CMOS-kompatible(s) Material(ien) umfasst;
• ein zweites Modul (40₂), das zum Definieren eines zweiten linearen Arrays von N₂ Qubits ausgelegt ist, umfassend:
- einen zweiten Silicium-Nanodraht (55₂), der sich entlang einer dritten Richtung erstreckt, die quer zu der ersten Richtung ist, und der eine dritte und eine vierte stumpfe oder spitze Kante aufweist, die entlang der dritten Richtung verlaufen, wobei die dritte Kante zwischen einer dritten Seitenfläche und einer oberen oder unteren Fläche des zweiten Halbleiter-Nanodrahts liegt und die vierte Kante zwischen einer vierten Seitenfläche und der oberen oder unteren Fläche des zweiten Silicium-Nanodrahts liegt;
- ein zweites Gatter-Dielektrikum (7), das unter oder über der dritten und der vierten Kante des Nanodrahts liegt, wobei das Gatter-Dielektrikum auf der dritten und der vierten Seitenfläche und auf der oberen Fläche oder unter der unteren Fläche vorgesehen ist, wobei das Gatter-Dielektrikum CMOS-kompatibles Material umfasst; und
- ein zweites lineares Array von geteilten Gattern (14), die entlang des zweiten Halbleiter-Nanodrahts entlang der zweiten Richtung beabstandet sind, wobei jedes geteilte Gatter über den Nanodraht in einer vierten, quer verlaufenden Richtung verläuft, wobei jedes geteilte Gatter ein drittes und ein viertes Gatter (12₁, 12₂) umfasst, die unter oder über der dritten bzw. der vierten Kante liegen, wobei das Gatter-Dielektrikum zwischen dem geteilten Gatter und dem zweiten Halbleiter-Nanodraht zwischengeschaltet ist und das geteilte Gatter CMOS-kompatible(s) Material(ien) umfasst;
• eine Verzweigung (50), die zum steuerbaren Koppeln jeweiliger Enden des ersten und des zweiten Moduls ausgelegt ist, um zu ermöglichen, dass Ladung und/oder Spin von dem Ende eines des ersten und des zweiten Moduls extrahiert werden und bewegt werden, um dem Ende des anderen des ersten und des zweiten Moduls präsentiert zu werden, wobei die Verzweigung Folgendes umfasst:
- einen zweidimensionalen Siliciumkanal (86); und
- mindestens drei Gatterstapel (82₃, 82_{C}, 82₂), die auf dem Siliciumkanal vorgesehen sind, um eine Reihe von Knoten in einem Pfad zwischen den Enden des ersten und des zweiten Moduls bereitzustellen, wobei jeder Stapel ein Gatter (82; Fig. 6) und ein Gatter-Dielektrikum (77; Fig. 6) umfasst, das zwischen dem Siliciumkanal und dem Gatter zwischengeschaltet ist, wobei das Gatter-Dielektrikum ein CMOS-kompatibles Material umfasst und das Gatter CMOS-kompatible(s) Material(ien) umfasst.

2. Qubit-Verarbeitungseinheit nach Anspruch 1, umfassend:
eine gemeinsame Silicium-Mesa (55), die den ersten und den zweiten Silicium-Nanodraht (55₃, 55₂) und den zweidimensionalen Siliciumkanal (86) bereitstellt.

3. Qubit-Verarbeitungseinheit nach Anspruch 1 oder 2, wobei N₁ = N₂ = 16.

4. Qubit-Verarbeitungseinheit nach einem der Ansprüche 1 bis 3, wobei die erste und die dritte Richtung senkrecht sind.

5. Qubit-Verarbeitungseinheit nach einem der Ansprüche 1 bis 4, wobei der erste und der zweite Silicium-Nanodraht (55₃, 55₂) eine erste und eine zweite Länge L₁, L₂ aufweisen, die in einem Bereich zwischen 0,5 µm und 50 µm, optional zwischen 1 µm und 5 µm liegen.

6. Qubit-Verarbeitungseinheit nach einem der Ansprüche 1 bis 5, wobei die Verzweigung (50) Folgendes umfasst:
fünf Gatterstapel, die auf dem Siliciumkanal (86) in einer Kreuzform vorgesehen sind, einschließlich:
eines mittleren Gatterstapels (82_{C});
eines ersten und eines dritten Gatterstapels (82₁, 82₃), wobei der erste, der mittlere und der dritte Gatterstapel in einer ersten Linie angeordnet sind, die entlang der ersten Richtung verläuft; und
eines zweiten und eines vierten Gatterstapels (82₂, 82₄), wobei der zweite, der mittlere und der vierte Gatterstapel in einer zweiten Linie angeordnet sind, die entlang der zweiten Richtung verläuft.

7. Qubit-Verarbeitungseinheit nach Anspruch 6, wobei die erste und die zweite Linie durch die Mitte des mittleren Gatterstapels (82_{C}) verlaufen, wobei die jeweiligen Mitten des ersten und des dritten Gatterstapels (82₁, 82₃) angeordnet sind, um auf beiden Seiten der ersten Linie zu liegen, und wobei die jeweiligen Mitten des zweiten und des vierten Gatterstapels (82₂, 82₄) angeordnet sind, um auf beiden Seiten der zweiten Linie zu liegen.

8. Qubit-Verarbeitungseinheit nach einem der Ansprüche 1 bis 7, wobei die Verzweigung (50) Folgendes umfasst:
ein Array von a×b Gatterstapeln (82₋₁₋₁, 82_{0,-1}, ...82_{C} ... 82_{0,+1}, 82₊₁₊₁), wobei a und b positive ganze Zahlen ungleich null sind, a ≥ 3 und b ≥ 3 und wobei optional a und b ungerade Zahlen sind, zum Beispiel a = b = 3.

9. Einrichtung, umfassend:
ein n×m-Array der Qubit-Verarbeitungseinheiten nach einem der Ansprüche 1 bis 8, wobei n ≥ 2 und m ≥ 2, wobei eine Verzweigung (50_{i,j}) in einer ersten Qubit-Verarbeitungseinheit mit einem ersten Modul (40_{X,i,j}) einer zweiten ersten Qubit-Verarbeitungseinheit und einem zweiten Modul (40_{Y,i,j}) einer dritten Qubit-Verarbeitungseinheit verbunden ist.

10. System, umfassend:
die Einrichtung nach Anspruch 9; und
eine Kältemaschine (102) zum Kühlen der Einrichtung auf unter 1 K.

11. System, umfassend:
die Einrichtung nach Anspruch 9 oder das System nach Anspruch 10; und
ein Steuer- und Ablesesystem (100), das angeordnet ist, um die geteilten Gatter (14) und die Gatter (82) zu steuern.

12. Verfahren zum Betreiben der Qubit-Verarbeitungseinheit nach einem der Ansprüche 1 bis 8, wobei das Verfahren Folgendes umfasst:
Veranlassen, dass ein Elektron (95) von unter einem des ersten und des zweiten Gatters (12₁) in einem geteilten Gatter (14_{3,1}) eines proximalen Endes des ersten Moduls (40₃) übertragen wird und zu einem ersten Knoten (82₃) in dem Pfad übertragen wird;
Veranlassen, dass das Elektron über einen zweiten Knoten (82_{C}) in dem Pfad zu einem dritten Knoten (82₂) benachbart zu einem des ersten und des zweiten Gatters (12₂) in einem geteilten Gatter (14_{2,1}) eines proximalen Endes des zweiten Moduls (40₂) übertragen wird;
Durchführen eines Zwei-Qubit-Quantengatterbetriebs;
Veranlassen, dass das Elektron über den zweiten Knoten zu dem ersten Knoten übertragen wird; und
Veranlassen, dass das Elektron zu unter einem des ersten und des zweiten Gatters in einem geteilten Gatter eines proximalen Endes des ersten Moduls übertragen wird.

13. Verfahren nach Anspruch 12, wobei der Zwei-Qubit-Quantengatterbetrieb ein CNOT-Gatter (SB1) ist.

14. Verfahren nach Anspruch 12 oder 13, ferner umfassend:
vor dem Veranlassen, dass das Elektron (95) von unter einem des ersten und des zweiten Gatters (12₁) in dem geteilten Gatter (14_{3,1}) des proximalen Endes des ersten Moduls (40₃) übertragen wird, Durchführen eines Einzel-Qubit-Gatterbetriebs.

15. Verfahren nach einem der Ansprüche 12 bis 14, wobei die Verzweigung (50") mindestens ein Array von a×b Gatterstapeln (82₋₁₋₁, 82_{0,-1}, ...82_{C} ... 82_{0,+1}, 82₊₁₊₁) umfasst, wobei a und b positive ganze Zahlen ungleich null sind, a ≥ 3 und b ≥ 3 und wobei optional a und b ungerade Zahlen sind, zum Beispiel a = b = 3, wobei das Verfahren Folgendes umfasst:
Veranlassen, dass zwei Elektronen (95, 98) gleichzeitig innerhalb der Verzweigung übertragen werden.

## Revendications

1. Unité de traitement de bits quantiques comprenant :
• un premier module (40₃) adapté pour définir un premier réseau linéaire de N₁ bits quantiques, comprenant :
- un premier nanofil de silicium (55₃) s'étendant le long d'une première direction comportant des premier et second bords obtus ou aigus courant le long de la première direction, ledit premier bord étant situé entre une première face latérale et une face supérieure ou inférieure du premier nanofil de silicium et ledit second bord étant situé entre une seconde face latérale et la face supérieure ou inférieure du premier nanofil de silicium ;
- un premier diélectrique de porte (7) sous-jacent ou recouvrant les premier et second bords du nanofil, le diélectrique de porte étant disposé sur les première et seconde faces latérales, et sur la face supérieure ou sous la face inférieure, le diélectrique de porte comprenant un ou plusieurs matériaux compatibles CMOS ; et
- un premier réseau linéaire de portes fractionnées (14) espacées le long du premier nanofil semi-conducteur le long de la première direction, chaque porte fractionnée courant à travers le premier nanofil de silicium dans une seconde direction transversale, chaque porte fractionnée comprenant des première et deuxième portes (12₁, 12₂) sous-jacentes ou recouvrant les premier et second bords respectivement, le diélectrique de porte interposé entre la porte fractionnée et le premier nanofil semi-conducteur et la porte fractionnée comprenant un ou des matériaux compatibles CMOS ;
• un second module (40₂) adapté pour définir un second réseau linéaire de N₂ bits quantiques, comprenant :
- un second nanofil de silicium (55₂) s'étendant le long d'une troisième direction qui est transversale à la première direction et qui comporte des troisième et quatrième bords obtus ou aigus courant le long de la troisième direction, ledit troisième bord étant situé entre une troisième face latérale et une face supérieure ou inférieure du second nanofil semi-conducteur et ledit quatrième bord étant situé entre une quatrième face latérale et la face supérieure ou inférieure du second nanofil de silicium ;
- un second diélectrique de porte (7) sous-jacent ou recouvrant les troisième et quatrième bords du nanofil, ledit diélectrique de porte étant disposé sur les troisième et quatrième faces latérales, et sur la face supérieure ou sous la face inférieure, le diélectrique de porte comprenant un matériau compatible CMOS ; et
- un second réseau linéaire de portes fractionnées (14) espacées le long du second nanofil semi-conducteur le long de la seconde direction, chaque porte fractionnée courant à travers le nanofil dans une quatrième direction transversale, chaque porte fractionnée comprenant des troisième et quatrième portes (12₁, 12₂) sous-jacentes ou recouvrant les troisième et quatrième bords respectivement, le diélectrique de porte interposé entre la porte fractionnée et le second nanofil semi-conducteur et la porte fractionnée comprenant un ou des matériaux compatibles CMOS ;
• une jonction (50) adaptée pour coupler de manière commandable les extrémités respectives des premier et second modules pour permettre à la charge et/ou au spin d'être extraits de l'extrémité de l'un des premier et second modules et d'être déplacés de façon à être présentés à l'extrémité de l'autre des premier et second modules, la jonction comprenant :
- un canal de silicium bidimensionnel (86) ; et
- au moins trois empilements de porte (82₃, 82_{C}, 82₂) disposés sur le canal de silicium de façon à fournir une série de nœuds dans un trajet entre les extrémités des premier et second modules, chaque empilement comprenant une porte (82 ; Fig. 6) et un diélectrique de porte (77 ; Fig. 6) interposé entre le canal de silicium et la porte, le diélectrique de porte comprenant un matériau compatible CMOS et la porte comprenant un ou plusieurs matériaux compatibles CMOS.

2. Unité de traitement de bits quantiques de la revendication 1, comprenant :
un mésa de silicium commun (55) qui fournit les premier et second nanofils de silicium (55₃, 55₂) et le canal de silicium bidimensionnel (86).

3. Unité de traitement de bits quantiques de la revendication 1 ou 2, N₁ = N₂ = 16.

4. Unité de traitement de bits quantiques de l'une quelconque des revendications 1 à 3, lesdites première et troisième directions étant perpendiculaires.

5. Unité de traitement de bits quantiques de l'une quelconque des revendications 1 à 4, lesdits premier et second nanofils de silicium (55₃, 55₂) comportant des première et seconde longueurs L₁, L₂ qui se situent dans une plage comprise entre 0,5 µm et 50 µm, éventuellement entre 1 µm et 5 µm.

6. Unité de traitement de bits quantiques de l'une quelconque des revendications 1 à 5, ladite jonction (50) comprenant :
cinq empilements de porte disposés sur le canal de silicium (86) dans une forme de croix comprenant :
un empilement central de portes (82_{C}) ;
des premier et troisième empilement de portes (82₁, 82₃), ledit premier empilement de porte, ledit empilement central et ledit troisième empilement de portes étant agencés selon une première ligne courant le long de la première direction ; et
des deuxième et quatrième empilement de portes (82₂, 82₄), ledit deuxième empilement de portes, ledit empilement de portes central et ledit quatrième empilement de portes étant agencés dans une seconde ligne courant le long de la seconde direction.

7. Unité de traitement de bits quantiques de la revendication 6, lesdites première et deuxième lignes courant à travers le centre de l'empilement de portes central (82_{C}), lesdits centres respectifs des premier et troisième empilement de portes (82₁, 82₃) étant agencés pour se trouver de chaque côté de la première ligne et lesdits centres respectifs des deuxième et quatrième empilements de portes (82₂, 82₄) étant agencés pour se trouver de chaque côté de la seconde ligne.

8. Unité de traitement de bits quantiques de l'une quelconque des revendications 1 à 7, ladite jonction (50) comprenant :
un réseau d'empilements de portes a×b (82₋₁₋₁, 82_{0,-1}, ...82_{C}... 82_{0,+1}, 82₊₁₊₁), où a et b sont des entiers positifs non nuls, a ≥ 3 et b ≥ 3 et, éventuellement, où a et b sont des nombres impairs, par exemple a = b = 3.

9. Appareil comprenant :
un réseau n×m des unités de traitement de bits quantiques de l'une quelconque des revendications 1 à 8, où n ≥ 2 et m ≥ 2, où une j onction (50_{i,j}) dans une première unité de traitement de bits quantiques est connectée à un premier module (40_{X,i,j}) d'une deuxième première unité de traitement de bits quantiques et à un second module (40_{Y,i,j}) d'une troisième unité de traitement de bits quantiques.

10. Système comprenant :
l'appareil de la revendication 9 ; et
un réfrigérateur (102) pour refroidir l'appareil à une température inférieure à 1 K.

11. Système, comprenant :
l'appareil de la revendication 9 ou le système de la revendication 10 ; et
un système de commande et de lecture (100) agencé pour commander les portes fractionnées (14) et les portes (82).

12. Procédé de fonctionnement de l'unité de traitement de bits quantiques de l'une quelconque des revendications 1 à 8, le procédé comprenant :
l'entraînement d'un transfert d'un électron (95) de sous l'une des première et seconde portes (12₁) dans une porte fractionnée d'extrémité proximale (14_{3,1}) du premier module (40₃) et de son transfert à un premier nœud (82₃) dans le trajet ;
l'entraînement du transfert de l'électron par l'intermédiaire d'un deuxième nœud (82_{C}) dans le trajet vers un troisième nœud (82₂) adjacent à l'une des première et deuxième portes (12₂) dans une porte fractionnée d'extrémité proximale (14_{2,1}) du second module (40₂) ;
la réalisation d'une opération de porte quantique à deux bits quantiques ;
l'entraînement du transfert de l'électron par l'intermédiaire du deuxième nœud vers le premier nœud ; et
l'entraînement du transfert de l'électron sous l'une des première et seconde portes dans une porte fractionnée d'extrémité proximale du premier module.

13. Procédé de la revendication 12, ladite opération de porte quantique à deux bits quantiques étant une porte CNOT (SB1).

14. Procédé de la revendication 12 ou 13, comprenant en outre :
avant d'entraîner le transfert de l'électron (95) de sous l'une des première et seconde portes (12₁) dans la porte fractionnée d'extrémité proximale (14_{3,1}) du premier module (40₃), la réalisation d'une opération de porte à un seul bit quantique.

15. Procédé de l'une quelconque des revendications 12 à 14, ladite jonction (50") comprenant au moins un réseau d'empilements de portes a×b (82₋₁₋₁, 82_{0,-1}, ...82_{C}... 82_{0,+1}, 82₊₁₊₁), où a et b sont des entiers positifs non nuls, a ≥ 3 et b ≥ 3 et, éventuellement, où a et b sont des nombres impairs, par exemple a = b= 3, le procédé comprenant :
l'entraînement du transfert simultané de deux électrons (95, 98) à l'intérieur de la jonction.
